# EUROPEAN PATENT APPLICATION

(11) **EP 4 102 558 A1**
(43) Date of publication of application: **14.12.2022**
(21) Application number: 21178804.7
(22) Date of filing: 10.06.2021
(51) Int. Cl.: H01L 23/64, H01L 23/538, H01L 25/07, H03K 17/082, H02M 7/00

(54) **POWER SEMICONDUCTOR MODULE**

(71) Applicant: Hitachi Energy Switzerland AG, 5400 Baden (CH)
(72) Inventor: KICIN, Slavo, 8049 Zürich (CH); SCHROEDER, Arne, 3012 Bern (CH); YAGHOUBI, Farhad, 5400 Baden (CH)
(74) Representative: Epping - Hermann - Fischer

(57) **Abstract**

The disclosure relates to a power semiconductor module (1) comprising at least two groups (2, 3; 31, 32, 33, 34) of semiconductor switches (4) connected in parallel, the semiconductor switches (4) of each group being connected in parallel within the group (2, 3; 31, 32, 33, 34), a module gate contact (5), a group gate contact (6,7) for each group, a first branching point (8) connected to the module gate contact (5) and to the group gate contacts (6, 7), a gate path between the module gate contact (5) and the first branching point (8) being shared for the at least two groups of semiconductor switches (2, 3; 31, 32, 33, 34), and a compensation structure (9; 39) in a connection path between the first branching point (8) and gate terminals (10) of the semiconductor switches (4) of at least one group (3) of semiconductor switches (4) for increasing the inductance of said connection path.

## Description

The present disclosure relates to a power semiconductor module comprising at least two parallel groups of semiconductor switches, the semiconductor switches of each group being connected in parallel. From EP 3113223 A1 a power semiconductor module is known in which several power semiconductor switches are connected using separate substrate metallizations which are arranged in a stacked manner.

To obtain lower switching losses of power module, it is an option to use wide-band-gap semiconductors which have in principle a fast switching behavior. However, the use of fast switching semiconductors raises new challenges to the design of modules. Additionally, the area of a typical wide-band-gap semiconductor device is considerably smaller than the area of a Si-device today; therefore, many more of them have to be connected in parallel if higher current rating is targeted.

It is an object to provide a power semiconductor module which is based on wide-band-gap semiconductors and comprises many semiconductor switches connected in parallel and which has a fast switching behavior.

According to an embodiment, the object is achieved by a semiconductor module comprising
- at least two groups of semiconductor switches connected in parallel, the semiconductor switches of each group being connected in parallel within the group,
- a module gate contact,
- a group gate contact for each group,
- a first inner branching point connected to the module gate contact and to the group gate contacts,
- a connection path between the external gate contact and the inner branching point being shared for the at least two groups of semiconductor switches, and
- a compensation structure in a connection path between the first branching point and the gate terminals of the semiconductor switches of at least one group for increasing the inductance of said connection path.

The described embodiment has an improved gate connection, since the proposed compensation structure makes it possible to better match the gate inductances of different groups of semiconductor switches. Also for large numbers of semiconductor switches connected in parallel, an improved switching behavior with shorter switching times, less oscillations and less power loss can be achieved.

The compensation structure effects an artificial prolongation of the gate path. Artificial prolongation means that the connection is longer than required for an electrical connection and is suitable to establish a substantial effect on the inductance of the path between the first branching point and the gate terminals of the semiconductor switches of at least one group. Substantial effect means that the inductance increases by e.g. more than 5% or more than 10% or more than 20% compared to said gate path section without such artificial prolongation. If a higher compensation is required, the prolongation can also be more than 50%, 100% or 150%.

It is an advantage of this embodiment that the connection between the module gate contact and the branching point can be used for connecting all gate terminals, therefore only minimum space is be required inside the module.

In addition to that, also the connection between the group gate contacts and the gate terminals of the semiconductor switches can be configured without additional correction measures. For the object to obtain a better switching performance it is primarily important to adjust the connection between the branching point and the group gate contacts.

It is also an advantage of the proposed embodiment that not the absolute value of the inductance has to be reduced to a minimum, but improvement can also be achieved by only reducing differences of inductances of the connection paths to the different groups of semiconductor switches.

It is a further advantage of the proposed embodiment that resistors which are normally used to attenuate the oscillations between semiconductor switches can be omitted or at least reduced. This improves the switching behavior which leads for example to the reduction of losses.

With a sufficient reduction of oscillations it is at least possible to replace thick film resistor by semiconductor-based resistors which facilitates production of the module and reduces production costs.

According to more detailed embodiments the compensation structure comprises a meander like structure formed in a metallization layer, a spiral like structure formed in a metallization layer and/or meander wires connecting islands formed in a metallization layer or it can be a discrete device, e.g. an inductor. All these technologies enable a good adjustment of the inductance without the need of much additional space in the module.

According to a further embodiment at least one group gate contact is configured with a compensation structure. Such a group gate contact is often provided with a relatively large surface area which is sufficient to form the compensation structure. Therefore no additional space in the module is required at all.

In an alternative embodiment the compensation structure is arranged between the first branching point and at least one group gate contact which enables a flexible configuration without modification of the group gate contact configuration.

In a further embodiment the compensation structure is implemented only for groups of semiconductor switches which have a shorter geometrical distance to the branching point than other groups. That means that the inductances of the shorter connection paths are adjusted to match better with the longer connection paths.

In a further embodiment the basically same compensation structure is applied to the group gate contacts of several groups of semiconductor switches. The compensation effect is selectively, i.e. individual for each of the related groups attenuated or deactivated by at least partly excluding the compensation structure from the gate path. For example a shortcut by bond wire can deactivate or attenuate the compensation effects depending on where the group of semiconductor switches is arranged within the module. As the structure of the metallization layer of the group gate contacts is the same for all groups, production costs can be reduced.

It is advantageous to use at least one of: MOSFETs, MISFESTs, JFETs or IGBTs, based on Si or a wide bandgap material such as SiC or GaN as semiconductor switches in the embodiments described.

The present disclosure comprises an additional aspect of the improvement of the gate connection, which is the reduction of the inductance of connections within the module. According to this aspect, bond wire connections for a gate and a source path are replaced by an interconnection bridge in which conductive layers are used for the gate and source path. The proposed layer structure comprises an insulation layer which is arranged between the conductive layers. Since gate and source path belong to same control loop and according to the physics of parallel conductors, the inductance can be reduced. The thickness of the insulation layer is less than 150 µm and even better less than 80 µm.

This aspect can be applied in addition to the increase of inductances as described above. The over-all gate inductance can thereby be reduced because for some gate connections the inductance can be reduced and for some others the inductance is increased. This way, the difference between the highest inductance and lowest inductance can be reduced to almost zero. However, also a reduction of inductance differences is a very effective measure for avoiding oscillations and enabling fast switching behavior. In a very good case the gate resistors provided for suppressing oscillations can be omitted. This further improves the performance of the power semiconductor module.

Every feature described with respect to one of the aspects is also disclosed herein with respect to the other aspect, even if the respective feature is not explicitly mentioned in the context of the specific aspect.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
- Fig. 1: is a schematic view of a first embodiment of power semiconductor module,
- Fig. 2: is a diagram showing the effect of the first embodiment on the gate inductance,
- Fig. 3: shows a second exemplary embodiment,
- Fig. 4: shows the vertical structure of the embodiment of Fig. 3,
- Fig. 5 to: 7 show exemplary embodiments of compensation structures,
- Fig. 8: shows an embodiment of a compensation structure with attenuation of the compensation effect,
- Fig. 9: is a schematic view of a further embodiment of a power module,
- Fig. 10: shows a compensation structure with two compensation outputs,
- Fig. 11: is a further embodiment with an additional interconnections bridge,
- Fig. 12: is a view of an interconnection bridge and
- Fig. 13: shows a detail of the interconnection bridge of Fig. 12.

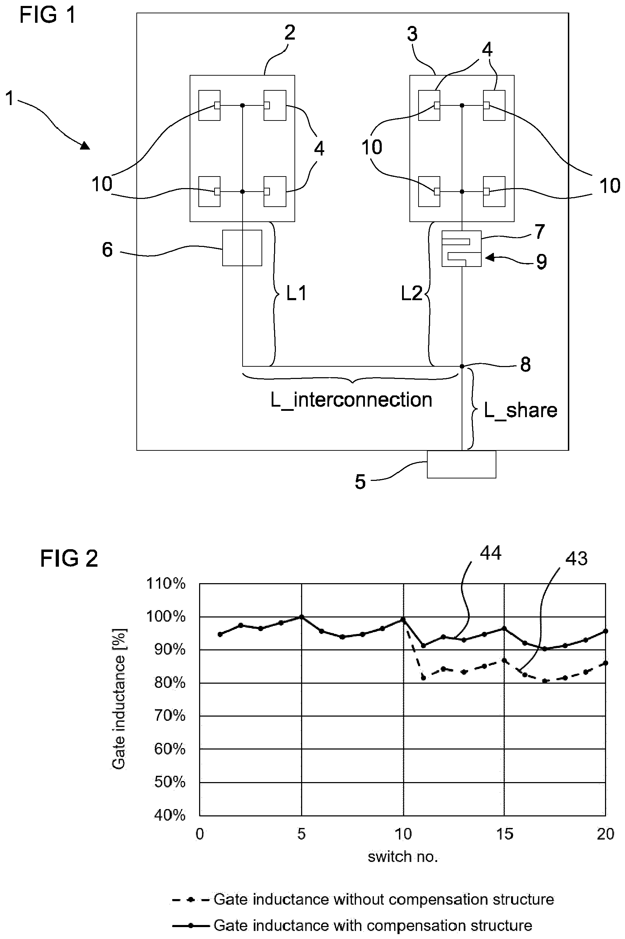

Fig. 1 is a schematic view of a power module 1 comprising two groups 2 and 3 of semiconductor switches 4. The gate terminals 10 of the semiconductor switches 4 are connected to a module gate contact 5. The length of the conduction path between the module gate contact 5 and the gate terminals 10 of the semiconductor switches 4 depends on the geometric arrangement of the components within the module. For example, if more than two groups of semiconductor switches are provided, it is impossible to achieve an equal length of the connection paths for each of the groups of semiconductor switches.

The unequal length of the conduction paths became a problem when the use of wide-band-gap semiconductors such as silicon carbide SiC or gallium nitride GaN became more popular to overcome limitations of silicon based power semiconductor devices. Exemplarily, silicon carbide and gallium nitride based devices are attractive because of their fast switching capability resulting in low switching losses. When using many wide-band-gap semiconductor switches in a module, strong oscillations within the modules were observed. To attenuate such oscillations, resistors are commonly used in the gate paths. Often a resistor with 5 Ω is sufficient to suppress oscillations. However, for providing such a resistor the use of thick film technology was required which means that an additional production step was necessary. While it is possible this way to suppress oscillations, the initial advantages of wide-band-gap semiconductors, namely the fast switching capability, cannot be fully exploited.

According to the present disclosure it is not the aim to suppress oscillations but to avoid them by providing improved design. Thereby, the approach is not to minimize inductances in the connection paths which is difficult with only limited design options, but to equalize them. While the switching capability of the power semiconductor module also depends from the total inductance of the gate path, oscillations strongly depend on the difference of inductances is in the paths to different groups of semiconductor switches.

In other words, to be able to switch fast, module stray inductance must be sufficiently low to avoid critical voltage overshoots, and inductance imbalance must be low to avoid oscillations between semiconductor switches.

The inductance of the gate path of the first group 2 can be described as a shared inductance L_shared + interconnection inductance L_interconnection + inductance L1, while the inductance of the second gate path can be described as shared inductance L_shared + L2. As can be seen from Fig. 1, the path to the second group 3 comprises a compensation structure 9 which is used to increase inductance of this connection path in order to equalize the total inductances of the gate path to first group 2 and the gate path to second group 3.

Assuming that 1 mm of the typical bond wire is increasing inductance of the gate path of about 1 nH, one can see that the difference in gate inductance between semiconductor switches can be easily more than 10 nH. In a specific module design, e.g. the
shared inductance can be dominating while the inductance differences within a group of semiconductor switches can be neglected. That means for a more balanced inductance situation, that one should focus on the interconnection inductance.

The proposed features are beneficial for example in design of complex high-power modules based on many silicon carbide or gallium nitride devices located on several substrates and connected in parallel. However it can be implemented also in other smaller power modules as shown in Fig. 1.

In the schematic view of Fig. 1 group gate contacts 6 and 7 are implemented. In the context of this application, a group gate contact is a common point of connection to the gate terminals of semiconductor switches belonging to this group. If a plurality of similar semiconductor switches is arranged on a common substrate, each of the substrates has a common group gate contact. It is also possible that several substrates are combined in a sub-module. While the geometric arrangement of the group gate contact in relation to the semiconductor switches of a group is often similar for all groups comprised in the power semiconductor module 1, the length of the connection paths from the module gate contact to the group gate contacts may vary between the groups. It should be noted, that the above-mentioned shared inductance L_shared means that the first part of the connection paths to the gate terminals is used in common until a branching point from where the paths to the different groups are separated.

Since the connection path to the first group 2 in Fig. 1 is much longer than to the second group 3, the total inductance for the first group 2 is higher than for the second group 3. Accordingly, a compensation structure 9 is implemented in the connection path between the branching point 8 and the gate terminals of the semiconductor switches 4 of the second group 3. In this embodiment, the compensation structure 9 comprises a meander like structure which is formed in a metallization layer.

Figure 2 shows the effect of a compensation structure in such an embodiment.
For example, it is possible to group 10 semiconductor switches (4) on one substrate of the module and another 10 semiconductor switches (4) on another substrate of the module. 20 semiconductor devices (4) located on both substrates are connected in parallel. In the case of half-bridge module configuration, such two substrates would represent upper or lower side of the module. Another such two substrates, connected in parallel, would form the other semiconductor switch of this half-bridge module. In such an embodiment, there are accordingly 40 semiconductor switches which are arranged in four groups (two and two connected in parallel).

In the diagram of Figure 2 the relative gate inductance in % of the maximum value is drawn for each semiconductor switch located on any of two substrates connected in parallel. Semiconductor switches 1 to 10 belong to a first group and are located in this embodiment on one substrate and semiconductor switches 11 to 20 to a second group, located on another substrate. As can be seen from the dashed line 17 which shows the gate inductance for a power semiconductor module without compensation structure, the maximum difference of gate inductance is 22%, while the difference within a group is only 7%. By using a compensation structure 9, the inductance of the gate path of the second group is increased as can be seen from the solid line 18. In an arrangement with compensation structure the maximum difference of gate inductances is only 11 nH, that means approximately half of the gate inductance difference without compensation structure.

As further effect, oscillations are reduced and thereby the switching speed can be increased. Measurements of the applicant have shown that the amplitude of oscillations of the gate voltage could be reduced to about 70%. Due to reduced oscillations, the power loss over the switching time could be reduced as well.

Another positive effect of using the idea of this disclosure is that a resistor can be at least reduced to a value of less than 2 Ω. Such resistors can be implemented as semiconductor-based resistors and do not require additional production steps during module assembly.

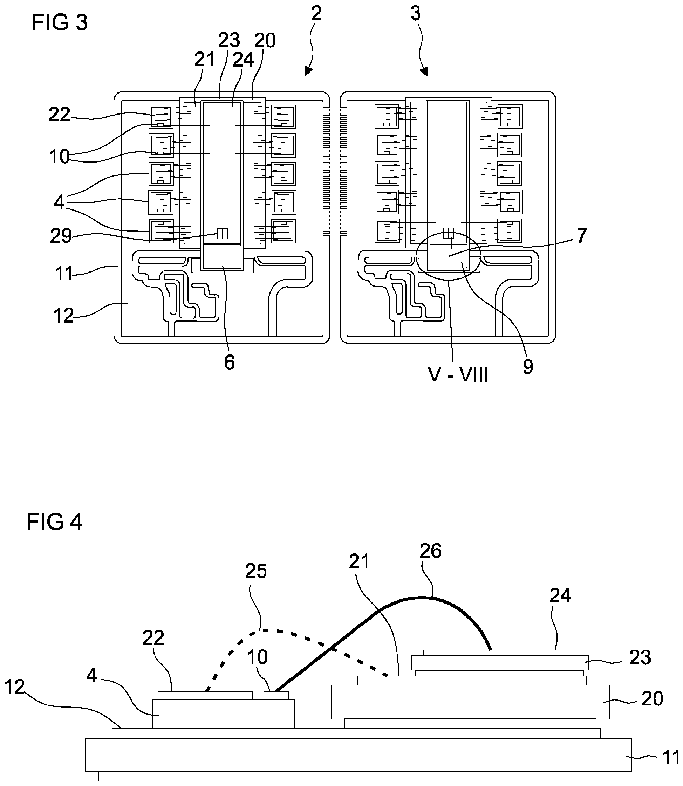

Fig. 3 shows a more detailed view of groups of semiconductor switches 4. Semiconductor switches 4 are arranged on a metallization layer 12 of a common substrate 11. The first metallization layer 12 is used as drain connection. In the stacked configuration of this embodiment, a second substrate 20 with a second metallization layer 21 is arranged on the first metallization layer 12 or the first substrate 11. Source terminals 22 of the semiconductor switches 4 are connected by bond wires 25 to the second metallization layer 21.

On the metallization layer 21 a third substrate 23 with a third metallization layer 24 is arranged. The third metallization layer 24 is used as bus bar to connect the gate terminals 10 of the semiconductor switches 4. The connection between gate terminals 10 and metallization layer is implemented by bond wires 26. A smaller part of the third metallization layer 24 is separated and constitutes a group gate contact 6. The third metallization layer 24 is connected to the group gate contact 6 via a resistor 29 and a bond wire.

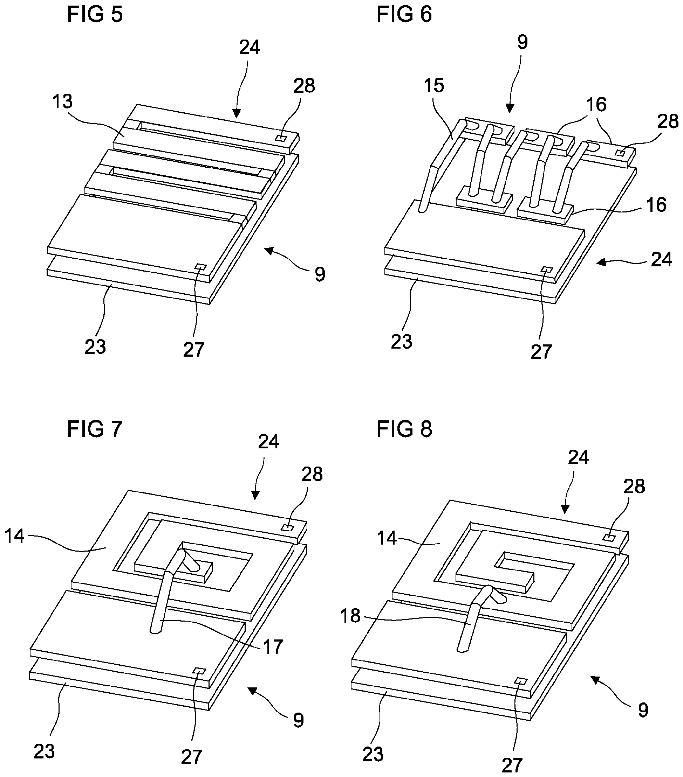

The second group 3 is substantially the same as the first group 2. As a difference, the first group 2 is not provided with a configuration structure, while the group gate contact 7 of the second group 3 is modified with a compensation structure 9. Details of the compensation structure are shown in Figures 5 to 9.

The vertical structure of the arrangement of Fig. 3 is shown in Fig. 4. This exemplary embodiment relates to a MOSFET-based arrangement which uses SiC. For such wide-band-gap semiconductors, the main benefits are assumed. However, the solution may be beneficial and considered also for Si-based power modules and other types of semiconductor switches if improved balance of gate inductance is required.

On the bottom side a substrate 11 is provided which has a metallization layer 12 on its upper surface. On the metallization layer 12 a semiconductor switch 4 is placed which has a source terminal 22 and a gate terminal 10. The source terminal 22 is connected to the second metallization layer 21 by a bond wire 25 and a gate terminal 10 is connected to a metallization layer 24 by a bond wire 26.

Figures 5, 6 and 7 show different configurations of compensation structures 9 which can be applied to group gate contact 7 in Fig. 3. The metallization layer 24 on the third substrate 23 is designed to form a meander like structure. It is obvious from Fig. 5 that the current path from a first contact point 27 to a second contact point 28 is much longer than on a direct line from point 27 to point 28. The arrangement of Fig. 5 can easily be used as a replacement or modification of the group gate contact 6 or 7. While traces coming from the module gate contact 5 are connected to the contact point 27 of the compensation structure 9, contact point 28 is connected via another bond wire to the resistor 29 and then to the third metallization layer 24 or, if no resistor is used, contact point 28 is contacted directly to the metallization layer 24.

In Fig. 6, an alternative embodiment is shown. In this embodiment islands 16 are provided on the substrate 23 and the incoming contact point 27 is connected via bond wires 15 with the islands in a for example meander like configuration.

In another alternative embodiment as shown in Fig. 7, a spiral like configuration is used which has the same purpose to increase the inductance of the path between contact points 27 and 28. Contact point 27 is connected to the central point of the spiral by a bond wire 17.

Inductance of the gate path can be increased also by adding of a discrete device increasing inductance.

It should be noted, that the configurations of Figures 5, 6 and 7 can be combined in further embodiments.

In a further embodiment the effect of a compensation structure can be attenuated or disabled by excluding or partly excluding the compensation structure from the gate path. This is shown in Fig. 8 where the bond wire 18 is connected to not to the central point of the spiral like compensation structure but approximately to the middle of the spiral path, so that the connection path via the compensation structure is still longer than the direct line between points 27 and 28, but not as long as it could be. Such a configuration can be used for example if the basically same structure in the metallization layer shall be applied to several group gate contacts although the increase of inductance must be varied depending on the location of the group of semiconductor switches within the module and the length of the conduction paths to the module gate contacts.

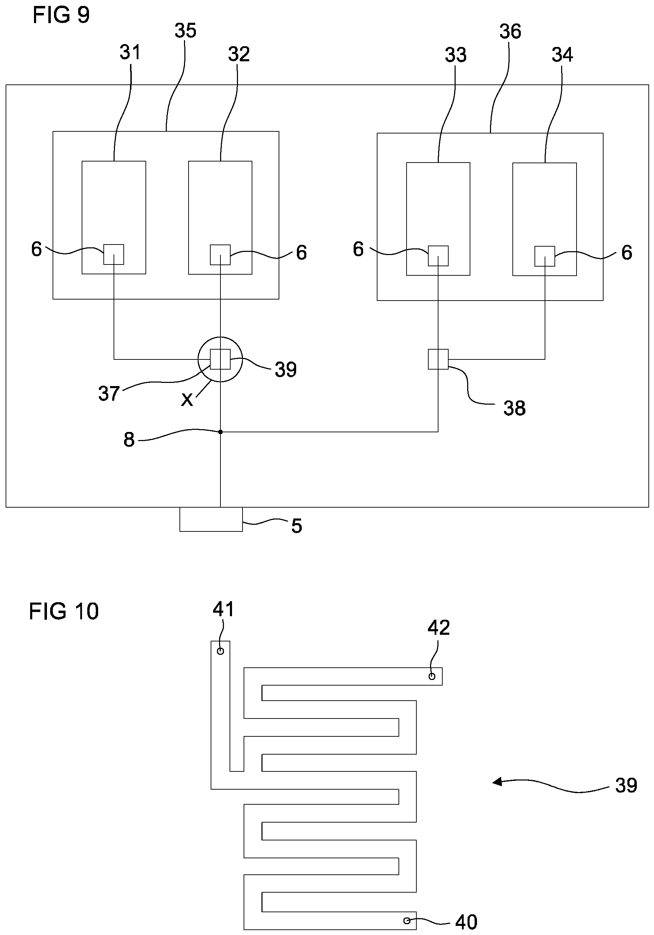

Another embodiment is shown in Fig. 9. According to this embodiment four groups of semiconductors 31 to 34 are provided. Two groups each form a submodule 35 and 36. On the backside of the submodules additional groups of semiconductor switches can be arranged. In such an embodiment eight groups of semiconductor switches are used. A similar configuration can be used for power semiconductor with less or more groups.

In the embodiment of Fig. 9, two levels of branching points are provided. Between the module gate contact 5 and a first branching point 8, the gate path is shared for all semiconductor switches. At the first branching point 8, the gate paths are split off for the first submodule 35 and the second submodule 36. In the left branch a second branching point 37 is provided where the gate path is split off for the first group of semiconductor switches 31 and a second group 32. The same configuration is provided for the second submodule 36 where a third branching point 38 is provided. While the third branching point 38 is a simple connection point, second branching point 37 is formed as a configuration structure 39 which is effective for increasing the gate inductance of the first and second group 31 and 32.

The configuration of the compensation structure 39 is shown in more detail in Fig. 10. It shows a meander like structure which has an "incoming" contact point 40 which is connected to the module gate contact 5, and two "outgoing" contact points 41 and 42 which are connected to the second group 32 or first group 31, respectively. As becomes obvious from Fig. 10, the connection path from contact point 40 to contact point 41 is shorter than from contact point 40 to contact point 42. This way different lengths of the paths from the branching point 37 to the group gate contacts 6 can be individually compensated, i.e. the additional inductance can be configured to be higher for the second group 32 than for the first group 31.

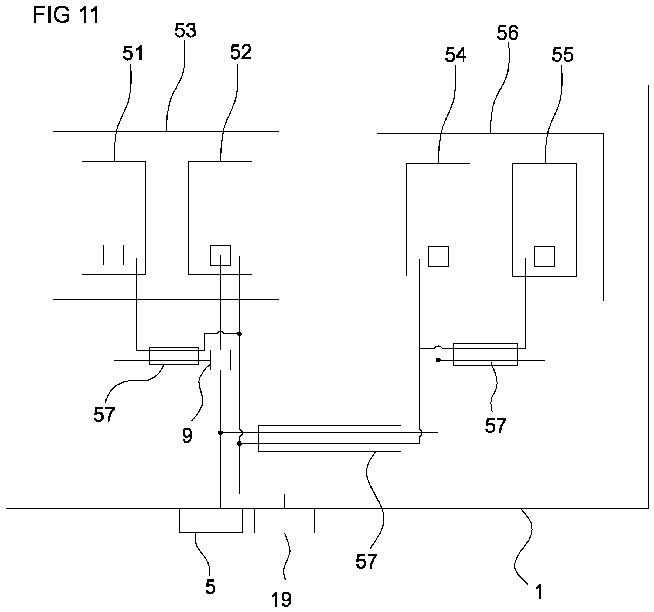

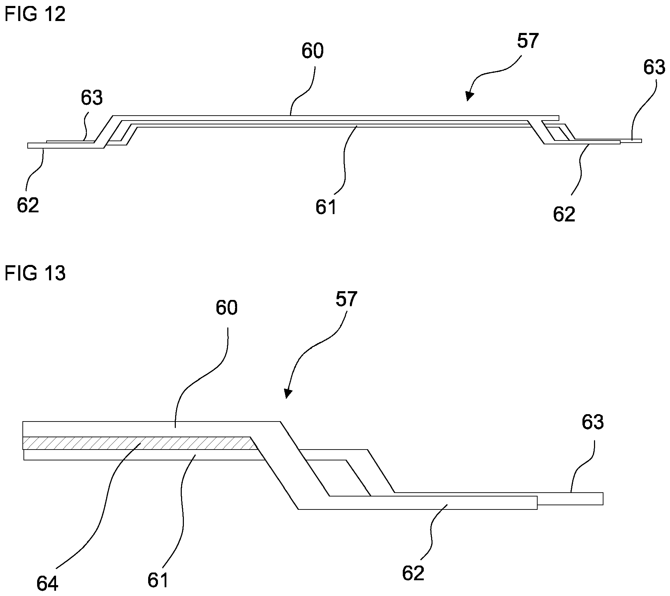

Figure 11 shows an embodiment which includes the second aspect of the present disclosure as mentioned above. Groups 51 and 52 of semiconductor switches are integrated within a submodule 53. Two additional groups 54 and 55 of semiconductor switches are integrated within a second submodule 56. Each of the submodules 53 and 56 comprises a connection between the groups via an interconnection bridge 57 as described below in connection with Figures 12 and 13. Also the gate and source connection between the submodules 53 and 56 can be implemented as interconnection bridge 57. The technical background of usage of the interconnection bridge 57 is that the compensation structure might not be able to sufficiently equalize the gate inductances. In some cases it would be possible to increase the inductances to reach this target, but the total inductance would be too high and cause oscillations or very slow switching times.

With the interconnection bridges it is possible to reduce the inductance of some gate paths, so that on the one hand some low inductances can be increased and some other, high inductances can be reduced. For the functionality of the interconnection bridges it is important that the source paths, i.e. the paths between a module source contact 19 and source terminals of the semiconductor switches has to be included. If other types of semiconductor switches are used instead of MOESFETs, the source terminals might have another name, while the same technical effect is achieved. Overall, a sufficient equalization of gate inductances can be achieved without being faced with a high total inductance.

An interconnection bridge comprises a layer structure with
- a first conductive layer for a gate connection,
- a second conductive layer for a source connection and
- an insulating layer arranged between the first and the second conductive layer.

The interconnection bridge is connected in the control loop of a semiconductor switch, i.e. a current flowing to the gate terminal thought the first conductive layer is also flowing at least partly though the second conductive layer, but in the opposite direction.

It should be noted that for the technically effect of interconnection bridges 57 connection paths for gate and source are required, while for a compensation structure only the gate path has to be modified.

Figure 12 shows a detail of the embodiment of Figure 11 which relates to the interconnection bridges 57. An interconnection bridge 57 comprises two conductive layers 60 and 61. While the layer 60 is used as gate connection, layer 61 is used as source connection. Both layers are separated by an insulating layer which is not shown in this figure. On both sides of the interconnection bridge 57, feet 62 for the gate connection and feet 63 for the source connection are provided. These feet are connected to the gate terminals or source terminals of the semiconductor switches, respectively, via traces on the substrates where the semiconductor switches are placed. One or more additional layers can be applied to increase the mechanical stability of the bridge or a glue can be added to provide additional support. This can become necessary for example for very long interconnection bridges.

Figure 13 shows an more detailed view of the interconnection bridge 57. As can be seen from this figure, the conductive layers 60 and 61 are separated by an insulating layer 64. The closer the conductive layers 60 and 61 are, the better the inductive coupling between the conductive layers gets. And the better the coupling is, the lower is the inductance of the gate connection. Therefore a thin insulating layer is beneficial for the performance of the power semiconductor module. It is beneficial if the thickness of the insulating layer is less than 150 µm or even less than 80 µm.

The embodiments shown in Figures 1 to 13 as stated represent exemplary embodiments of the improved arrangement of a power semiconductor module. Therefore, they do not constitute a complete list of all embodiments according to the improved arrangement. Actual arrangements may vary from the embodiments shown in terms of arrangements or devices.

### Reference Signs

- 1: power semiconductor module
- 2: group of semiconductor switches
- 3: group of semiconductor switches
- 4: semiconductor switch
- 5: module gate contact
- 6: group gate contact
- 7: group gate contact
- 8: first branching point
- 9: compensation structure
- 10: gate terminal
- 11: first substrate
- 12: first metallization layer
- 13: meander like structure
- 14: spiral like structure
- 15: wired meander structure
- 16: islands
- 17: bond wire
- 18: bond wire
- 19: module source contact
- 20: second substrate
- 21: second metallization layer
- 22: source terminal
- 23: third substrate
- 24: third metallization layer
- 25: bond wire
- 26: bond wire
- 27: first contact point
- 28: second contact point
- 29: resistor
- 31: group of semiconductor switches
- 32: group of semiconductor switches
- 33: group of semiconductor switches
- 34: group of semiconductor switches
- 37: second branching point
- 38: third branching point
- 39: compensation structure
- 40: "incoming" contact point
- 41: "outgoing" contact point
- 42: "outgoing" contact point
- 43: gate inductance without compensation structure
- 44: gate inductance with compensation structure
- 51: group of semiconductor switches
- 52: group of semiconductor switches
- 53: submodule
- 54: group of semiconductor switches
- 55: group of semiconductor switches
- 56: submodule
- 57: interconnection bridge
- 60: conductive layer
- 61: conductive layer
- 62: foot
- 63: foot
- 64: insulating layer

## Claims

1. A power semiconductor module (1) comprising
- at least two groups (2, 3; 31, 32, 33, 34) of semiconductor switches (4) connected in parallel, the semiconductor switches (4) of each group being connected in parallel within the group (2, 3; 31, 32, 33, 34),
- a module gate contact (5),
- a group gate contact (6,7) for each group,
- a first branching point (8) connected to the module gate contact (5) and to the group gate contacts (6, 7),
- a gate path between the module gate contact (5) and the first branching point (8) being shared for the at least two groups of semiconductor switches (2, 3; 31, 32, 33, 34),
- a compensation structure (9; 39) in a connection path between the first branching point (8) and gate terminals (10) of the semiconductor switches (4) of at least one group (3) of semiconductor switches (4) for increasing the inductance of said connection path.

2. The power semiconductor module (1) according to claim 1, characterized that the compensation structure (9; 13; 14; 15; 39) includes an artificial prolongation of the gate path.

3. The power semiconductor module (1) according to claim 2, characterized that the artificial prolongation is more than 5%, 10 % or 20%.

4. The power semiconductor module (1) according to claim 2 or 3, characterized that the compensation structure (9; 13; 14; 15; 39) is formed by one or more of the following features:
- formed in the metallization of ceramic substrate or PCB,
- formed by wire bonds or
- formed as a discrete device.

5. The power semiconductor module (1) according to one of claims 1 to 3,
**characterized in that** the compensation structure (9) is formed in a metallization layer (12; 24) by one or more of the following features: a meander like structure (13) or a spiral like structure (14).

6. The power semiconductor module (1) according to one of claims 1 to 3,
**characterized in that** the compensation structure (15) comprises wires connecting islands (16) formed in a metallization layer (12; 24).

7. The power semiconductor module (1) according to one of claims 1 to 6,
**characterized in that** at least one group gate contact (6) is configured with a compensation structure (9).

8. The power semiconductor module (1) according to one of claims 1 to 6,
**characterized in** the that the compensation structure (9) is arranged between the first branching point (8) and at least one group gate contact (6, 7).

9. The power semiconductor module (1) according to one of claims 1 to 8,
**characterized in that** a geometrical distance between the first branching point (8) and the group gate contacts (6, 7) is different for at least two groups (2, 3; 31, 32, 33, 34) of semiconductor switches (4), and the compensation structure (9) is implemented only for groups of semiconductor switches (4) with less than the largest geometrical distance.

10. The power semiconductor module (1) according to claim 7,
**characterized in that** the same compensation structure (9) is formed for each of several group gate contacts (6, 7) with an exception that a compensation effect is selectively attenuated or deactivated by at least partly excluding the compensation structure (14) from the gate path.

11. The power semiconductor module (1) according to one of claims 1 to 10,
**characterized in that** the inductance of a compensation structure in form of a first compensation structure for a first group of semiconductor switches (4) is different from the inductance of a compensation structure in form of a second compensation structure for a second group of semiconductor switches (4).

12. The power semiconductor module (1) according to at least one of claims 1 to 11,
**characterized by** at least one second branching point (37,38) in a gate path.

13. The power semiconductor module (1) according to at least one of claims 1 to 11,
**characterized in that** several semiconductor switches (4) of a group of semiconductor switches are arranged on a substrate (11) with a first metallization layer (12), with a stacked second substrate (20) with a second metallization layer (21) as source connection layer and a stacked third substrate (23) with a third metallization layer (24) as gate connection layer.

14. The power semiconductor module (1) according to at least one of claims 1 to 13,
**characterized in that** the semiconductor switches (4) are at least one of: MOSFETs, MISFETs, JFETs or IGBTs based on Si or a wide bandgap material.

15. The power semiconductor module (1) according to at least one of claims 1 to 14,
**characterized in that** the group gate contacts (6, 7) are connected to the gate terminals (10) of the semiconductor switches (4) belonging to the group directly or via a semiconductor-based resistor (29) with a resistance of less than 3 Ω.
